# FASCICULE DE BREVET EUROPEEN

(11) **EP 3 124 983 B1**
(45) Date de publication et mention de la délivrance du brevet: **11.12.2019**
(21) Numéro de dépôt: 15306233.6
(22) Date de dépôt: 29.07.2015
(51) Int. Cl.: G01R 19/155, A42B 3/04, G08B 21/02, G08B 3/10, G08B 5/36, G01R 29/08

(54) **SYSTÈME DE SÉCURITÉ INDIVIDUELLE COMPRENANT UN DÉTECTEUR DE TENSION ET UN SYSTÈME D'ÉCLAIRAGE ET ENSEMBLE DE SÉCURITÉ INDIVIDUELLE COMPRENANT UN TEL SYSTÈME**
INDIVIDUELLES SICHERHEITSSYSTEM, DAS EINEN SPANNUNGSDETEKTOR UND EIN BELEUCHTUNGSSYSTEM UMFASST, UND INDIVIDUELLE SICHERHEITSEINHEIT, DIE EIN SOLCHES SYSTEM UMFASST
INDIVIDUAL SECURITY SYSTEM COMPRISING A VOLTAGE SENSOR AND A LIGHTING SYSTEM AND INDIVIDUAL SECURITY ASSEMBLY COMPRISING SUCH A SYSTEM

(43) Date de publication de la demande: 01.02.2017
(73) Titulaire: Fameca Electronics, 68170 Rixheim (FR)
(72) Inventeur: Hirlay, Jean-Baptiste, 68200 MULHOUSE (FR); Philip, Michel, 68100 MULHOUSE (FR); Caqueux, Mickaël, 68530 BUHL (FR)
(74) Mandataire: Regimbeau

(56) Documents cités:
- CN-U- 201 504 614
- CN-U- 201 595 226
- US-A- 3 309 690
- US-B1- 6 329 924
- N.A. N.A.: "Digital potentiometer", www.resistorguide.com, 7 March 2013 (2013-03-07), pages 1-2, XP055491973, Retrieved from the Internet: URL:https://web.archive.org/web/2013030718 1607/http://www.resistorguide.com:80/digit al-potentiometer/ [retrieved on 2018-07-12]
- N.A. Dallas Semiconductor: "DS1869 3V Dallastat Electronic Digital Rheostat", , 20 November 1999 (1999-11-20), pages 1-8, XP055491928, Retrieved from the Internet: URL:https://datasheets.maximintegrated.com /en/ds/DS1869.pdf [retrieved on 2018-07-11]
- Chuck Wojslaw: "Push Button Control of Digital Potentiometers (DP) with an Increment/Decrement Interface", Design Note DN1, 14 September 2001 (2001-09-14), pages 1-2, XP055491978, Retrieved from the Internet: URL:https://www.nidec-copal-electronics.co m/e/catalog/digital-potentiometer/design-n ote/DN1.pdf [retrieved on 2018-07-12]
- N.A. N.A.: "Choosing the Correct digiPOT for Your Application", , 12 November 2014 (2014-11-12), pages 1-6, XP055491981, Retrieved from the Internet: URL:http://www.analog.com/media/en/news-ma rketing-collateral/product-selection-guide /Choosing_the_Correct_Digipot.pdf [retrieved on 2018-07-12]
- Chuck Wojslaw ET AL: "Single switch controls digital potentiometer", EDN, 7 February 2002 (2002-02-07), pages 100-100, XP055491982, Retrieved from the Internet: URL:https://m.eet.com/media/1140775/20702d i.pdf [retrieved on 2018-07-12]

## Description

### DOMAINE TECHNIQUE GENERAL ET ETAT DE LA TECHNIQUE

L'invention concerne les dispositifs de sécurité individuelle en particulier ceux destinés à la détection de tension et concerne et notamment ceux destinés à être portés par des individus susceptibles d'être exposés à des tensions dangereuses voire mortelles.

On connait des dispositifs de protection individuelle destinés à protéger des intervenants dans environnements dans lesquels peuvent régner des tensions dangereuses.

Il peut s'agir d'électriciens, de pompiers ou bien encore d'intervenants sur des chantiers divers.

Des dispositifs de sécurité individuelle connus sont des détecteurs de tension personnels qui permettent de détecter et de signaler à un utilisateur qu'il se trouve à proximité d'une tension dangereuse. En cas de signalement d'une telle tension, l'utilisateur peut alors prendre les précautions d'usage.

Ce type de dispositif est habituellement porté par l'utilisateur autour du cou ou bien fixé à un de ses vêtements.

Un problème est que dans ce cas, le corps de l'utilisateur fait écran aux champs électriques et empêche le détecteur de remplir sa fonction.

Le document US 3 309 690 A divulgue un système de sécurité individuelle comprenant un boîtier configuré pour être fixé à un casque avec un détecteur de tension, un système de signalisation, un système de fixation et un unique interrupteur permettant à la fois de régler un seuil de détection, d'interrompre le signal de signalisation et d'initialiser le seuil de détection à un niveau initial.

### PRESENTATION DE L'INVENTION

Un but de l'invention est d'améliorer les dispositifs de sécurité individuelle connus.

A cet effet, l'invention propose un système de sécurité individuelle selon la revendication 1.

L'invention est avantageusement complétée par les caractéristiques des revendications dépendantes.

Les avantages de l'invention sont multiples.

Grâce au positionnement à un emplacement optimal pour l'éclairage, le détecteur de tension est omnidirectionnel.

L'invention permet de pallier le problème de masquage du capteur par le corps humain. Le corps ne masquera que les objets sous l'opérateur ou à sa proche proximité. La détection se fera à l'approche du danger quelle que soit la progression du porteur de l'appareil : Marche avant, arrière, ou latérale.

En outre, le fait de prévoir un détecteur de tension couplé à un système d'éclairage permet d'avoir la double fonctionnalité détection/éclairage sans avoir à modifier le casque et permet d'utiliser le système dans l'obscurité.

### PRESENTATION DES FIGURES

D'autres caractéristiques, buts et avantages de l'invention ressortiront de la description qui suit, qui est purement illustrative et non limitative, et qui doit être lue en regard des dessins annexés sur lesquels :
- la figure 1 illustre schématiquement un système de sécurité individuelle selon un mode de réalisation ;
- la figure 2 illustre un casque configuré pour recevoir un système de sécurité individuelle selon un mode de réalisation ;
- la figure 3 illustre une vue partielle d'un casque sur lequel un système de sécurité selon un mode de réalisation est fixé ;
- la figure 4 illustre une vue en coupe de la figure 3 ;
- la figure 5 illustre un dispositif de fixation couplé d'un système de sécurité individuelle selon un mode de réalisation.

Sur l'ensemble des figures les éléments similaires portent des références identiques.

### DESCRIPTION DETAILLEE DE L'INVENTION

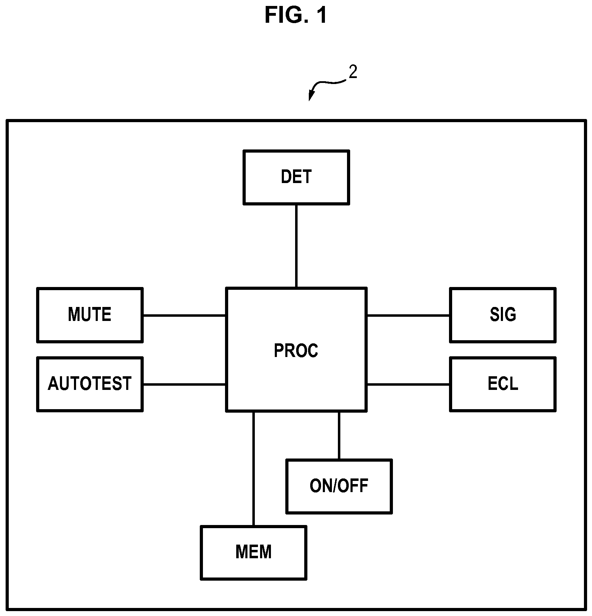

Selon un mode de réalisation illustré sur les **figures 1****,** **2** et **3****,** un système 1 de sécurité individuelle comprend un boitier 2 configuré pour être fixé à un casque 10 de protection.

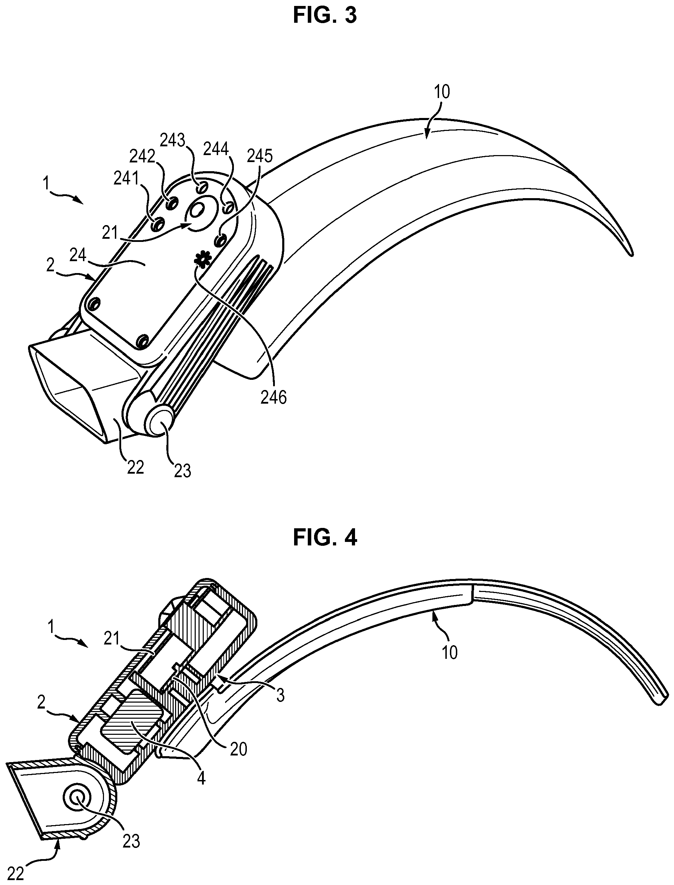

Le casque 10 de protection illustré sur la **figure 4** est notamment destiné à être porté par un utilisateur intervenant dans un environnement dans lequel il est susceptible d'être exposé à des tensions dangereuses voire mortelles (destiné à être porté sur la tête d'un individu). En particulier, le casque de la figure 4 est du type de ceux prévus par l'une des normes suivantes :
- EN 397 A1 -2013 : Casques de protection pour l'industrie ;
- EN 960 -2006 : Fausses têtes à utiliser lors des essais de casques de protection
- EN 13087-1 : 2000 : Casques de protection - Méthodes d'essais - Partie 1 : conditions et conditionnement
- EN 13087-2 : 2012 : Casques de protection - Méthodes d'essais - Partie 2 : Absorption des chocs
- EN 13087-3 : 2012 : Casques de protection - Méthodes d'essais - Partie 3 : Résistance à la pénétration
- EN 13087-4 : 2012 : Casques de protection - Méthodes d'essais - Partie 3 : Résistance à la pénétration
- EN 13087-5 : 2012 : Casques de protection - Méthodes d'essais - Partie 5 : Résistance du système de rétention
- EN 13087-6 : 2012 : Casques de protection - Méthodes d'essais - Partie 6 : Champ visuel
- EN 13087-7 : 2000 : Casques de protection - Méthodes d'essais - Partie 7 : Résistance à la flamme
- EN 13087-8 : 2005 : Casques de protection - Méthodes d'essais - Partie 8 : Propriétés électriques
- EN 13087-10 : 2012 : Casques de protection - Méthodes d'essais - Partie 10 : Résistance à la chaleur radiante
- EN 14052 + A1 -2012 : Casque de protection à haute performance pour l'industrie
- EN 50365 : 2002.08 : Casques électriquement isolants pour utilisation sur installations à basse tension.

Il s'agit des casques utilisés, par exemple, par des électriciens, sur des chantiers ou bien un casque de pompier.

Le boitier définit un logement 20 dans lequel sont notamment disposés :
un processeur PROC ;
un détecteur DET de tension couplé au processeur et configuré pour détecter un champ électrique tension ambiant ;
un système SIG de signalisation couplé au processeur, le processeur PROC transmettant un signal de signalisation par l'intermédiaire du système de signalisation SIG à destination d'un individu si le détecteur de tension détecte DET un champ électrique supérieur ambiant à un seuil de détection ;
un système d'éclairage ECL couplé au processeur PROC ;

un dispositif 3 de fixation couplé au boitier et configuré pour fixer le boitier 2 à un casque 10 de protection à un emplacement adapté pour éclairer autour de l'individu lorsque ce dernier porte le casque sur sa tête.

Le détecteur de tension est du type comprenant un élément sensible qui est un condensateur (en pratique composé de deux électrodes). Dès que le détecteur de tension se trouve dans un champ électrique, il prend une charge qui est propre au champ dans lequel il est placé et à sa géométrie propre.

En effet, une source de tension génère autour d'elle un champ électrique. C'est donc ce champ qui est détecté par le détecteur. Le champ électrique est induit par la différence de potentiels entre les sources de tension et leurs câbles de transports d'une part et la terre et ce qui y est plus ou moins couplé d'autre part.

On précise ici que l'on entend par champ ambiant le champ électrique régnant dans l'environnement immédiat de l'individu.

L'emplacement optimal pour éclairer autour de l'individu (portant le casque avec le système de sécurité) est de préférence sur la surface externe de la calotte 12 du casque 10, juste en dessous du sommet de la calotte. Bien entendu, il est sur le côté destiné à être au-dessus du front de l'individu.

L'homme du métier comprendra par conséquent ce que l'on entend par emplacement optimal pour éclairer autour de l'individu.

Le fait de prévoir que le détecteur DET de tension est à cet emplacement optimal permet d'avoir une détection omnidirectionnelle, c'est-à-dire à 360° autour de l'individu sans que son corps ne fasse écran à la détection du champ électrique.

En outre, le fait de coupler la fonction détection de tension à la fonction éclairage permet de bénéficier des deux fonctions en même temps (utilisation dans l'obscurité par exemple).

Le détecteur de tension DET permet de générer un signal de signalisation dès lors que l'individu entre dans une zone potentiellement dangereuse.

A ce titre, le système de sécurité comprend une mémoire MEM couplée au processeur PROC dans laquelle est stocké un seuil de détection initial SO.

Lorsque le détecteur détecte ce seuil, un signal de signalisation va être généré par le processeur PROC.

De manière alternative ou complémentaire on peut prévoir que le signal de signalisation est modulé proportionnellement à ce seuil de détection.

A ce titre, on peut prévoir un premier signal de signalisation lorsque le détecteur détecte une tension égale à 10% du seuil, un second signal de signalisation lorsque le détecteur détecte une tension égale à 20% du seuil etc. Bien entendu plusieurs types de loi de modulation peuvent être envisagées. Une telle modulation a pour avantage de prévenir l'individu qu'il se rapproche d'une zone dangereuse et inversement de l'éloignement de la zone dangereuse.

Une loi de modulation est à ce titre stockée dans la mémoire MEM.

De manière préférée, un système de signalisation peut par exemple être constitué par un signal sonore, le dispositif de sécurité comprenant alors un haut-parleur. Le niveau sonore sera alors plus ou moins fort si le signal de signalisation est modulé.

Alternativement, un système de signalisation peut par exemple être constitué par un signal lumineux, le dispositif de sécurité comprenant un dispositif lumineux dédié (non représenté) ou utilisant alors le système d'éclairage ECL. Dans ce cas, le signal lumineux peut consister à être clignotant pour être perçu par l'individu. Le clignotement sera plus ou moins rapide si le signal de signalisation est modulé.

De manière alternative ou complémentaire le système de sécurité comprend un premier interrupteur MUTE couplé au processeur PROC et configuré pour interrompre la génération du signal de signalisation et pour régler le seuil de détection à n fois le niveau détecté ayant conduit à la signalisation préalable, n étant une constante supérieure à 1.

Ceci permet d'informer l'individu de la dangerosité de la zone dans laquelle il se trouve tout en ne le dérangeant plus avec un signal de signalisation.

Le fait de relever le seuil de détection, implique qu'une nouvelle génération du signal de signalisation indiquera qu'il est dans une zone encore plus dangereuse.

De manière complémentaire, le système comprend un second interrupteur AUTOTEST couplé au processeur PROC et configuré pour initialiser le seuil de détection à un niveau initial.

Ceci est particulièrement utilisé lorsque le premier interrupteur a été utilisé. En fin d'intervention, ce second interrupteur permet de réinitialiser le système de sécurité individuelle.

En outre, avant l'utilisation le second interrupteur AUTOTEST permet de vérifier le bon fonctionnement du détecteur et remet à jour les seuils par défaut.

Comme indiqué précédemment, le système de sécurité individuelle est avantageux en ce qu'il regroupe la fonction éclairage avec la fonction de détecteur de tension.

En revenant aux figures 3 et 4, de manière avantageuse, le boitier 2 comprend une première partie 21 de boitier dans laquelle est disposée le détecteur de tension et une seconde partie 22 de boitier dans laquelle est disposé le système d'éclairage ECL.

Et de préférence, le système de sécurité individuelle comprend un dispositif 23 d'orientation de la seconde partie 22 par rapport à la première partie 21 de manière à orienter le système d'éclairage ECL.

De manière alternative, on peut prévoir d'utiliser un boitier dans lequel le détecteur de tension et le système d'éclairage ECL sont disposés dans la partie orientable (non représenté). Dans ce cas, le boitier est moins encombrant. Le système de détection peut intégrer plusieurs capteurs dont un logé dans la partie orientable afin de palier la faiblesse de sensibilité au sol devant l'opérateur.

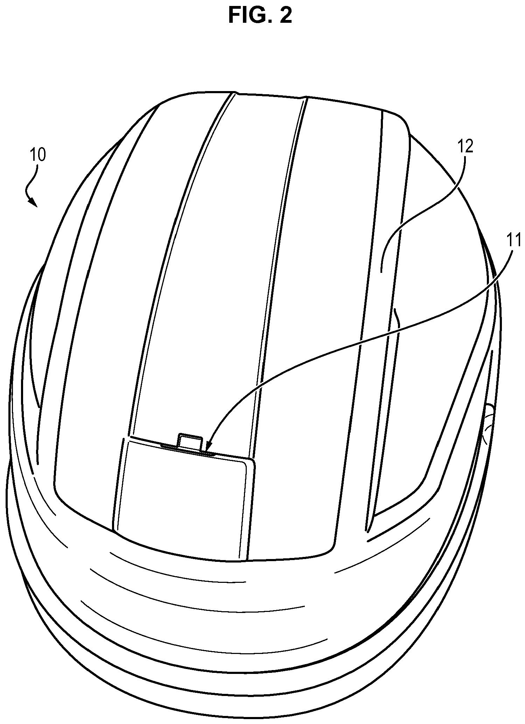

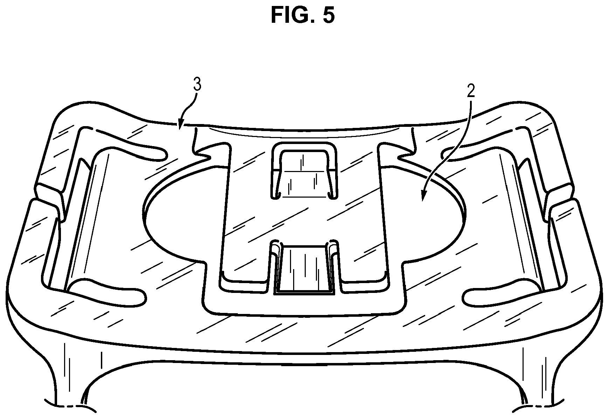

Sur la **figure 5** on a illustré un dispositif 3 de fixation couplé au boitier 2 et configuré pour fixer le boitier 2 au un casque 10 de la figure 2 lequel comprend un système de maintien 11 du système de sécurité disposé sur la surface extérieure de la calotte 12 du casque. En particulier, selon l'exemple illustré sur les figures 2 et 5, il s'agit d'un maintien du du type encoche/plot, le système de sécurité se « clipsant » dans l'encoche 11.

De manière alternative, le système de sécurité peut être fixé au casque par l'intermédiaire d'une sangle ou encore d'un système auto-agrippant.

En d'autres termes, il s'agit de ne pas modifier le casque en prévoyant soit de mettre le système de sécurité à un emplacement déjà prévu pour fixer une lampe soit en rajoutant un élément auto-agrippant ou bien en sanglant le système au casque.

A l'intérieur du boitier sont également logées les batteries 4 conférant une autonomie au système de sécurité individuelle (voir la figure 4). L'état des batteries peut aussi être vérifié lorsque le second interrupteur AUTOTEST est actionné.

Comme on peut le voir sur la figure 3, le boitier comprend un capot 24 sur lequel des emplacements 241, 242, 243, 244, 245, 246 sont prévus pour les premier et second interrupteurs MUTE, AUTOTEST, le système SIG de signalisation, un interrupteur marche arrêt ON/OFF, un voyant indicateur de l'allumage du système, un voyant de l'état de la batterie (pour s'assurer que le système de sécurité est autonome).

Le boitier est de préférence en matière plastique.

## Revendications

1. Système (1) de sécurité individuelle comprenant :
un boitier (2) configuré pour être fixé à un casque (10) de protection, dans lequel sont disposés :
un processeur (PROC) ;
un détecteur (DET) de tension configuré pour détecter un champ électrique ambiant ;
un système (SIG) de signalisation configuré pour émettre un signal de signalisation à destination d'un individu si le détecteur de tension détecte (DET) un champ électrique ambiant supérieur à un seuil de détection ;
un système d'éclairage (ECL) ;
un dispositif (3) de fixation couplé au boitier et configuré pour fixer le boitier (2) à un casque (10) de protection à un emplacement adapté pour éclairer autour de l'individu lorsque ce dernier porte le casque sur sa tête ;
ledit système de sécurité comprenant un premier interrupteur (MUTE) configuré pour interrompre la génération du signal de signalisation et pour régler le seuil de détection à n fois le niveau détecté ayant conduit à la signalisation préalable, n étant une constante supérieure à 1 ;
ledit système de sécurité comprenant un second interrupteur (AUTOTEST) configuré pour initialiser le seuil de détection à un niveau initial, ledit niveau initial étant stocké dans une mémoire (MEM) dudit système de sécurité, le détecteur (DET) de tension, le système (SIG) de signalisation, le système d'éclairage (ECL), le premier interrupteur (MUTE), le second interrupteur (AUTOTEST) et la mémoire étant couplés au processeur (PROC) .

2. Système de sécurité individuelle selon la revendication 1, dans lequel le boitier (2) comprend une première partie (21) de boitier dans laquelle sont disposés le détecteur de tension et une seconde partie (22) de boitier dans laquelle est disposé le système d'éclairage (ECL).

3. Système de sécurité individuelle selon la revendication 2, comprenant un dispositif (23) d'orientation de la seconde partie (22) par rapport à la première partie (21) de manière à orienter le système d'éclairage (ECL).

4. Système de sécurité individuelle selon l'une des revendications 1 à 3, dans lequel le système de signalisation (SIG) est constitué d'un haut-parleur.

5. Système de sécurité individuelle selon l'une des revendications 1 à 3, dans lequel le système de signalisation (SIG) est constitué par le système d'éclairage (ECL) lui-même, le signal de signalisation étant constitué par un clignotement du système d'éclairage.

6. Système de sécurité individuelle selon l'une des revendications 1 à 3, dans lequel le système de signalisation (SIG) est constitué d'un dispositif lumineux, le signal de signalisation étant constitué par un clignotement dudit dispositif lumineux.

7. Système de sécurité individuelle selon l'une des revendications 1 à 6, dans lequel le système de fixation est constitué d'un pion destiné à être inséré dans une encoche d'un casque (10)

8. Système de sécurité individuelle selon l'une des revendications 1 à 6, dans lequel le système de fixation est une sangle.

9. Système de sécurité individuelle selon l'une des revendications 1 à 6, dans lequel le système de fixation est du type auto-aggripant.

10. Ensemble de sécurité individuelle comprenant :
un casque (10) comprenant une calotte (12) ;
un système (1) de sécurité selon l'une des revendications précédentes fixé audit casque (10).

11. Ensemble de sécurité selon la revendication 10, dans lequel le casque comprend un système de maintien du système de sécurité disposé sur la surface extérieure de la calotte.

## Patentansprüche

1. Individuelles Sicherheitssystem (1), umfassend:
ein Gehäuse (2), konfiguriert, um auf einem Schutzhelm (10) fixiert zu werden, in dem angeordnet sind:
ein Prozessor (PROC);
ein Spannungsdetektor (DET), konfiguriert, um ein umgebungselektrisches Feld zu detektieren;
ein Signalisierungssystem (SIG), konfiguriert, um ein Signalisierungssignal an ein Individuum auszugeben, falls der Spannungsdetektor ein umgebungselektrisches Feld größer als eine Detektionsschwelle detektiert (DET);
ein Beleuchtungssystem (ECL);
eine Fixiervorrichtung (3), die an das Gehäuse gekoppelt ist, und konfiguriert, um das Gehäuse (2) auf einem Schutzhelm (10) an einer Stelle zu fixieren, die geeignet ist, um das Individuum herum zu beleuchten, wenn dieses Letztere den Helm auf dem Kopf trägt;
wobei das Sicherheitssystem einen ersten Schalter (MUTE) umfasst, konfiguriert, um die Erzeugung des Signalisierungssignals zu unterbrechen und die Detektionsschwelle auf n Mal die detektierte Stufe, die zur vorstehenden Signalisierung geführt hat, einzustellen, wobei n eine Konstante größer als 1 ist;
wobei das Sicherheitssystem einen zweiten Schalter (AUTOTEST) umfasst, konfiguriert, um die Detektionsschwelle auf eine Anfangsstufe zurückzusetzen, wobei die Anfangsstufe in einem Speicher (MEM) des Sicherheitssystems abgelegt ist, wobei der Spannungsdetektor (DET), das Signalisierungssystem (SIG), das Beleuchtungssystem (ECL), der erste Schalter (MUTE), der zweite Schalter (AUTOTEST) und der Speicher an den Prozessor (PROC) gekoppelt sind.

2. Individuelles Sicherheitssystem nach Anspruch 1, wobei das Gehäuse (2) einen ersten Gehäuseteil (21) umfasst, in dem der Spannungsdetektor und ein zweiter Gehäuseteil (22) angeordnet sind, in dem das Beleuchtungssystem (ECL) angeordnet ist.

3. Individuelles Sicherheitssystem nach Anspruch 2, eine Ausrichtungsvorrichtung (23) des zweiten Teils (22) im Verhältnis zum ersten Teil (21) umfassend, um das Beleuchtungssystem (ECL) auszurichten.

4. Individuelles Sicherheitssystem nach einem der Ansprüche 1 bis 3, wobei das Signalisierungssystem (SIG) durch einen Lautsprecher gebildet wird.

5. Individuelles Sicherheitssystem nach einem der Ansprüche 1 bis 3, wobei das Signalisierungssystem (SIG) durch das Beleuchtungssystem (ECL) selbst gebildet wird, wobei das Signalisierungssignal durch ein Blinken des Beleuchtungssystems gebildet wird.

6. Individuelles Sicherheitssystem nach einem der Ansprüche 1 bis 3, wobei das Signalisierungssystem (SIG) durch eine Leuchtvorrichtung gebildet wird, wobei das Signalisierungssignal durch ein Blinken der Leuchtvorrichtung gebildet wird.

7. Individuelles Sicherheitssystem nach einem der Ansprüche 1 bis 6, wobei das Fixiersystem aus einem Stift gebildet wird, der dazu bestimmt ist, in eine Kerbe eines Helms (10) eingeführt zu werden.

8. Individuelles Sicherheitssystem nach einem der Ansprüche 1 bis 6, wobei das Fixiersystem ein Gurt ist.

9. Individuelles Sicherheitssystem nach einem der Ansprüche 1 bis 6, wobei das Fixiersystem vom Typ selbsthaftend ist.

10. Individuelle Sicherheitseinheit, umfassend:
einen Helm (10), umfassend eine Schale (12);
ein Sicherheitssystem (1) nach einem der vorstehenden Ansprüche, das auf dem Helm (10) fixiert ist.

11. Sicherheitseinheit nach Anspruch 10, wobei der Helm ein System zum Halten des Sicherheitssystems umfasst, das auf der äußeren Oberfläche der Schale angeordnet ist.

## Claims

1. System (1) for individual security, comprising:
a case (2) configured to be fastened to a protective helmet (10), in which the following are disposed:
a processor (PROC);
a voltage detector (DET) configured to detect an ambient electric field;
a signalling system (SIG) configured to emit a signalling signal to an individual if the voltage detector detects (DET) an ambient electric field greater than a detection threshold;
a lighting system (ECL);
a fastening device (3) coupled to the case and configured to fasten the case (2) to a protective helmet (10) at a location adapted for lighting around the individual when the latter wears the helmet on their head;
said security system comprising a first switch (MUTE) configured to interrupt the generation of the signalling signal and to adjust the detection threshold to n times the detected level having led to the previous signalling, n being a constant greater than 1;
said security system comprising a second switch (AUTOTEST) configured to initialise the detection threshold to an initial level, said initial level being stored in a memory (MEM) of said security system, the voltage detector (DET), the signalling system (SIG), the lighting system (ECL), the first switch (MUTE), the second switch (AUTOTEST) and the memory being coupled to the processor (PROC).

2. System for individual security according to claim 1, wherein the case (2) comprises a first case portion (21) in which are disposed the voltage detector and a second case portion (22) in which the lighting system (ECL) is disposed.

3. System for individual security according to claim 2, comprising a device (23) for orienting the second portion (22) with respect to the first portion (21) in such a way as to orient the lighting system (ECL).

4. System for individual security according to one of claims 1 to 3, wherein the signalling system (SIG) consists of a speaker.

5. System for individual security according to one of claims 1 to 3, wherein the signalling system (SIG) consists of the lighting system (ECL) itself, the signalling system consisting of a blinking of the lighting system.

6. System for individual security according to one of claims 1 to 3, wherein the signalling system (SIG) consists of a light device, the signalling signal consisting of a blinking of said light device.

7. System for individual security according to one of claims 1 to 6, wherein the fastening system consists of a pin intended to be inserted into a notch of the helmet (10).

8. System for individual security according to one of claims 1 to 6, wherein the fastening system is a strap.

9. System for individual security according to one of claims 1 to 6, wherein the fastening system is of the self-attaching type.

10. Assembly for individual security, comprising:
a helmet (10) comprising a shell (12);
a security system (1) according to one of the previous claims fastened to said helmet (10).

11. Security assembly according to claim 10, wherein the helmet comprises a system for maintaining the security system disposed on the outer surface of the shell.
